# EUROPEAN PATENT APPLICATION

(11) **EP 1 381 076 A2**
(43) Date of publication of application: **14.01.2004**
(21) Application number: 03254245.8
(22) Date of filing: 03.07.2003
(51) Int. Cl.: H01L 21/00

(54) **Dicing tape applying apparatus and back-grinding/dicing tape applying system**

(30) Priority: 12.07.2002 JP 2002204704
(71) Applicant: TOKYO SEIMITSU CO.,LTD., Mitaka-shi Tokyo (JP)
(72) Inventor: Kobayashi, Kazuo c/o Tokyo Seimitsu Co., Ltd., Mitaka-shi Tokyo (JP)
(74) Representative: Rackham, Stephen Neil

(57) **Abstract**

A dicing tape applying apparatus (30) includes a pre-cut dicing tape edge position detector (44) for which detects the edge of a pre-cut dicing tape and a cutter (60) for cutting a non-cut dicing tape into a desired shape when it is applied. Such an apparatus (30) is able to use both non-cut dicing tape and pre-cut dicing tape.

## Description

The present invention relates to a dicing tape applying apparatus that applies a dicing tape to the back of a wafer before dicing and a back-grinding/dicing tape applying system that comprises a back-grinder that thins a wafer by grinding the back of the wafer and a dicing tape applying apparatus that applies a dicing tape to the back of the thinned wafer.

In manufacturing semiconductors, after many chips (dice) are formed on the surface of a wafer, semiconductor chips are completed through a dicing process in which dice are separated and an assembling process in which they are fixed to a lead frame or the like and bonding is performed. In the dicing process, grooves are formed between dice on the surface of a wafer by a dicing apparatus and the dice are separated. A dicing tape is applied to the back of the wafer to prevent the dice from scattering during separation.

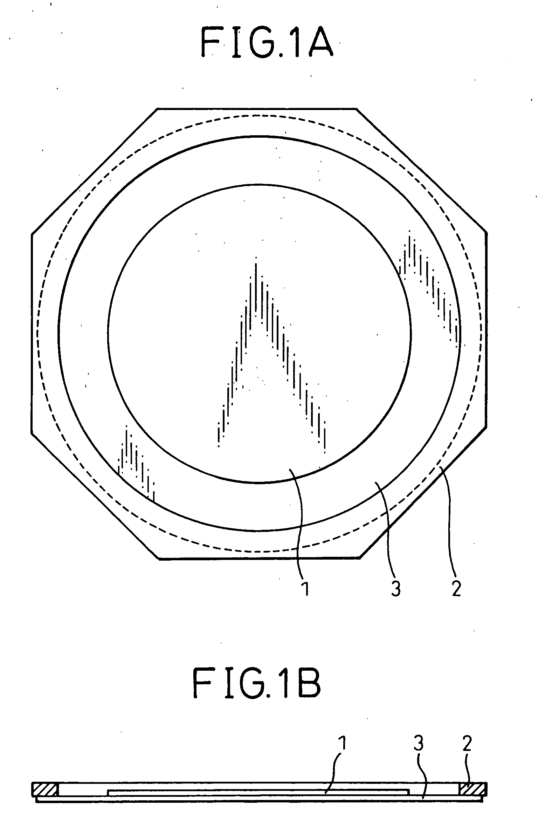

FIG. 1A and FIG. 1B are diagrams that show a state of a wafer before dicing, and FIG. 1A is a top view and FIG. 1B is a cross sectional view. As show schematically, a wafer 1 is arranged in a circular hole in a plate-shaped frame 2, and a dicing tape 3 is applied to the backs of the wafer 1 and the frame 2. A dicing apparatus forms many grooves between dice. The groove is formed so as to reach the dicing tape 3, but even when the wafer is cut into dice, the dice do not scatter because the dicing tape 3 is applied to their backs. In some cases, first the grooves are formed so that a part of the wafer is left uncut, then the wafer is separated completely in the assembling process. In the assembling process, bonding is performed in a state in which the part of the dicing tape 3 between the wafer and the frame is expanded (an expansion state) and each die is picked up one by one and fixed to a lead frame, a film for circuitry or the like. At this time, cooling or the like is performed so that the dice can be easily separated from the dicing tape 3.

To apply the dicing tape 3 to the backs of the wafer 1 and the frame 2, a dicing tape applying apparatus is used. In the dicing tape applying apparatus, in a state in which the surface of the wafer 1 and the surface of the frame 2 are retained on the stage, a dicing tape, the width of which is wider than the frame, is applied to the backs of the wafer 1 and the frame 2, the blade of a cutter is made to come into contact with the dicing tape on the frame and made to rotate to cut it into a circle, and after the dicing tape is peeled off, a circular dicing tape is left.

Recently, instead of cutting after the dicing tape is applied as described above, a dicing tape that has been cut into a fixed shape in advance and retained in a carrier film is applied. Here, a dicing tape that has been cut into a fixed shape in advance is referred to as a pre-cut dicing tape and a conventional dicing tape that has not been cut but that has to be cut later is referred to as a non-cut dicing tape. When a pre-cut dicing tape is used, no cutter is required, but it is necessary to provide a mechanism for supplying a pre-cut dicing tape with a detector that detects the edge position of a pre-cut dicing tape and, then, the tape is applied after alignment of the position with respect to the wafer and the frame retained at fixed positions.

As described above, after each die on the wafer that has finished the dicing process is fixed to a package such as a lead frame or a film for circuitry in the next assembling process, the electrode pad of the die and the electrode of the package are connected by a bonding wire or the like. A die is fixed to the package after an adhesive is applied to its back or to the package. As an adhesive has fluidity, it spreads to the periphery of the bonded surface of the package and the sides of the die and then solidifies. Because of the fluidity, there is a problem that the adhesive may spread as far as an undesirable part. For example, if the adhesive spreads to the surface of the die, the electric connection between the electrode pad and the connecting wire such as the bonding wire is adversely affected.

Therefore, a die bonding tape that fixes the package to the back of the die is applied. This tape is called the die attach film, the die bond film, and so on. Conventionally, a die bonding tape is applied to each die one by one, but in this case the efficiency is insufficient and, therefore, a tape composed of a dicing tape and a die bonding tape bonded to each other is applied to the back of the wafer, and the wafer and the die bonding tape are cut together. Then, in assembling, the die is peeled off from the dicing tape in a state in which the die bonding tape is attached to the back, and it is fixed to the package. The dicing tape uses a material, the adhesive force of which is different from that of the material the die bonding tape uses, so that it is possible to peel off the die from the dicing tape in a state in which the die bonding tape is attached to the die, and both the tapes are irradiated with ultraviolet rays, heated, cooled, and so on. The die bonding tape can be attached to both the non-cut dicing tape and the pre-cut dicing tape.

One of the recent trends is for a semiconductor apparatus to be mounted on a portable device or a card more frequently, and for a semiconductor chip (die) to be thinned accordingly. For this reason, the back of a wafer before dicing is ground with a grinder. This is called back-grinding, and an apparatus for back-grinding is called a back-grinder. Back-grinding is performed in a state in which a protective tape is applied to the surface for protection. When a wafer is back-ground, distortions are produced and they are removed by etching, but etching cannot be performed in a state in which the protective tape is applied, therefore, etching is performed after the protective tape is peeled off. By back-grinding, the wafer usually becomes less than about 150 µm in thickness.

Recently, instead of etching after back-grinding, polishing of the back of a wafer is performed to remove distortions and a polishing/back-grinding apparatus has prevailed. The apparatus has advantage in that back-grinding and polishing to remove distortions can be done with the same apparatus and, therefore, the manufacturing efficiency is high.

The back-ground wafer, after a dicing tape is applied to by the above-mentioned dicing tape applying apparatus, is separated into dice in dicing process, fixed to a package and assembled. Generally, the semiconductor manufacturing process is divided into a pre-process in which the wafer is processed and a post-process that is performed after all the processes on the wafer are completed. In some cases, for example, the pre-process is performed in one factory in one country and the post-process is performed in another factory in another country.

As described above, the dicing tape includes the non-cut dicing tape and the pre-cut dicing tape, and the non-cut dicing tape is used conventionally, but the pre-cut dicing tape has prevailed recently. The conventional non-cut dicing tape applying apparatus is not supposed to be used for applying the pre-cut dicing tape and, therefore, the apparatus cannot use the pre-cut dicing tape. Moreover, the pre-cut dicing tape applying apparatus is manufactured on the assumption that it uses the pre-cut dicing tape, therefore, it cannot use the non-cut dicing tape. A dicing tape applying apparatus is, as described above, one that can use only one kind of tape.

However, as described above, the non-cut dicing tape and the pre-cut dicing tape are used mixedly in the actual manufacturing process and, therefore, it is necessary to provide two dicing tape applying apparatuses, that is, one for the non-cut dicing tape and the other for the pre-cut dicing tape. This causes a problem that not only is the cost of equipment raised but also a large space for installation is required.

In addition, after etching is performed on the back-ground wafer after the protective tape is peeled off, or after its back is polished and then the protective tape is peeled off, it is contained in a wafer cassette, brought to a factory for post-processing, and it is diced and assembled.

As described above, the back-ground wafer is less than about 150 µm in thickness, and if there is dust or the like on a stage that retains the wafer when the protective tape is peeled off or the dicing tape is applied, the wafer may be easily damaged and a problem occurs that the yield is lowered.

The present invention has been developed with the above-mentioned problems being taken into consideration, and the first object is to realize a dicing tape applying apparatus that can be used for both the non-cut dicing tape and the pre-cut dicing tape for reducing the cost of equipment and saving space, and the second object is to realize a back-grinding/dicing tape applying system and a dicing tape applying apparatus to be used therein, which can reduce the damage rate of the back-ground wafer and raise the yield.

In order to realize the first object described above, a dicing tape applying apparatus according to a first aspect of the present invention comprises a pre-cut dicing tape edge position detector that detects the edge position of the pre-cut dicing tape and a cutter that cuts the applied non-cut dicing tape into a desired shape so that the dicing tape applying apparatus can be used for both the non-cut dicing tape and the pre-cut dicing tape.

In other words, the dicing tape applying apparatus according to the first aspect of the present invention is one that applies the dicing tape to a wafer to undergo dicing and is characterized by comprising a stage that retains the wafer, a dicing tape supply mechanism that can set both the non-cut dicing tape and the pre-cut dicing tape and that supplies the set non-cut dicing tape or the set pre-cut dicing tape, a pre-cut dicing tape edge position detector that detects the edge position of the pre-cut dicing tape when the pre-cut dicing tape is supplied from the dicing tape supply mechanism, a tape applying mechanism that applies the non-cut dicing tape or the pre-cut dicing tape supplied from the dicing tape supply mechanism to the back of the wafer, and a cutter that cuts the non-cut dicing tape into a desired shape when the non-cut dicing tape is applied.

The dicing tape applying apparatus according to the first aspect of the present invention can be used for both the non-cut dicing tape and the pre-cut dicing tape because it is able to cut the non-cut dicing tape into a desired shape when it is applied and it is also able to detect the edge position for position alignment and application of the tape by the pre-cut dicing tape edge position detector when the pre-cut dicing tape is applied.

The non-cut dicing tape and the pre-cut dicing tape can be those made by bonding the dicing tape and the die bonding tape to each other.

In order to realize the second object mentioned above, in a back-grinding/dicing tape applying system according to a second aspect of the present invention, distortions are removed by a polishing/back-grinding apparatus, the wafer is sent to a dicing tape applying apparatus in a state in which the protective tape applied to the surface during back-grinding is left as is, and the protective tape is peeled off after the dicing tape is applied.

In other words, the back-grinding/dicing tape applying system according to the second aspect of the present invention is characterized in that it comprises a polishing/back-grinding apparatus that thins the wafer, on the surface of which semiconductor circuits are formed and to the surface of which the protective tape is applied, by grinding and polishing its back, and a dicing tape applying apparatus that applies the dicing tape to the back of the thinned wafer, and in that the dicing tape applying apparatus peels off the protective tape after applying the dicing tape.

In the back-grinding/dicing tape applying system according to the second aspect of the present invention, the thinned wafer is sent to the dicing tape applying apparatus in a state in which the protective tape is applied, and the protective tape is peeled off after the dicing tape is applied, that is, the wafer is always in a state in which a tape is applied, therefore, damage is unlikely to occur.

It is necessary for the dicing tape applying apparatus used in a system according to the second aspect to peel off the protective tape after the dicing tape is applied. In addition, it is desirable that the apparatus can be used for both the non-cut dicing tape and the pre-cut dicing tape, similar to the first aspect.

A back-grinding/dicing tape applying system according to a third aspect of the present invention is characterized by comprising a back-grinder that thins the wafer, on the surface of which semiconductor circuits are formed, by polishing its back, a dicing tape applying apparatus that is arranged adjacent to the back-grinder and that applies the dicing tape to the back of the thinned wafer, and a conveying mechanism that conveys the thinned wafer from the back-grinder to the dicing tape applying apparatus.

Conventionally, the back-grinder and the dicing tape applying apparatus are arranged separately in different factories, therefore, it frequently happens that the thinned wafer has to be handled. Contrary to this, in the system according to the third aspect of the present invention, the back-grinder and the dicing tape applying apparatus are arranged adjacently and, therefore, the conveying path between them can be shortened and simplified, the frequency of wafer handling can be reduced, and the damage rate can also be reduced.

The features and advantages of the invention will be more clearly understood from the following description taken in conjunction with the accompanying drawings, wherein:
FIG. 1A and FIG.1B are diagrams that show a state in which a dicing tape is applied to a wafer and a frame.
FIG.2 is a diagram that shows the configuration of the part including a back-grinder and a dicing tape applying apparatus in the embodiments of the present invention.
FIG.3 is a diagram that shows the configuration of the dicing tape applying apparatus in the embodiments.
FIG.4 is a diagram that shows a pre-cut dicing tape used in the embodiments.
FIG.5A to FIG.5C are diagrams that illustrate how to apply a non-cut dicing tape in the dicing tape applying apparatus.
FIG. 6A to FIG.6H are diagrams that illustrate the changes of tapes to be applied in the back-grinding process and the dicing tape applying process.

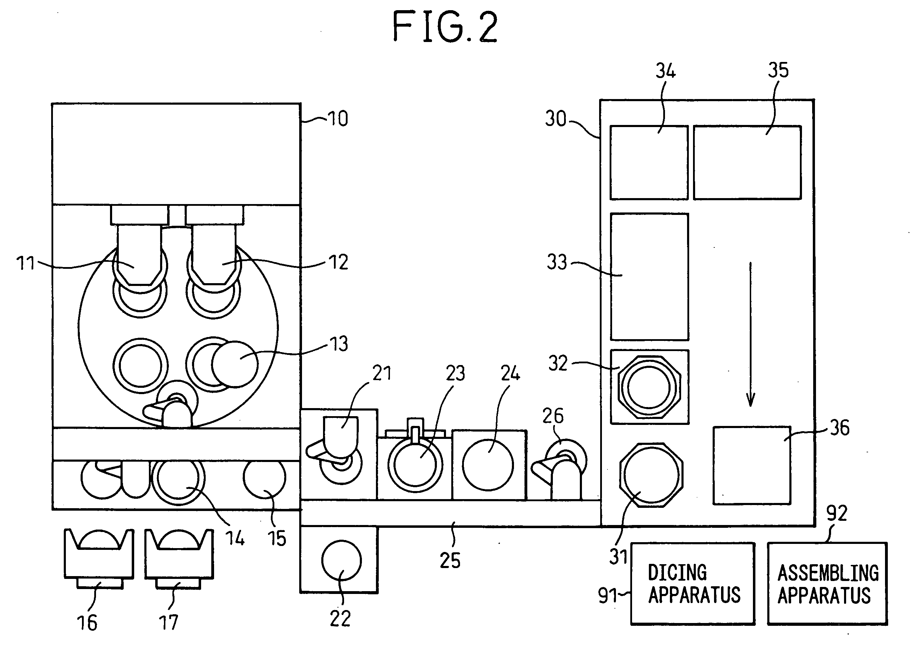

FIG.2 is a diagram that shows the configuration of a polishing/back-grinding apparatus and a dicing tape applying apparatus in the embodiments of the present invention in the semiconductor manufacturing process.

As shown in FIG.2, the wafer that has passed the probe test is supplied in a state of being contained in wafer cassettes 16 and 17. A protective tape is applied to the surface of the wafer. A robot arm of a polishing/back-grinding apparatus (PG) 10 takes out the wafer contained in the wafer cassettes 16 and 17 and conveys it onto the rotary table. As the table rotates, the wafer moves to a first grinder 11 and a second grinder and its back is polished (back-ground). Then, the wafer further moves to a polisher 13 and is polished to remove distortions. Then, the protective tapes on the back and surface of the wafer are cleaned by a cleaner 14 and the wafer is conveyed to a mounting base 15. A robot arm 21 conveys the thinned wafer on the mounting base 15 onto a base 22. The wafer is reversed in a die 22. Then, a robot arm 26 able to move on a track 25 conveys the wafer to an aligner 23. The aligner 23 detects an orient flat or notch of the wafer and adjusts the wafer to a fixed position and direction. Then, the robot arm 26 conveys the wafer from the aligner 23 to an UV irradiation apparatus 24. The UV irradiation apparatus 24 irradiates the protective tapes with ultraviolet rays to lessen the adhesive force of the protective tape. Then, the robot arm 26 conveys the wafer to a dicing applying apparatus 30.

The polishing/back-grinding apparatus 10 and the UV irradiation apparatus 24 described above are the same as conventional ones. The conventional procedure, in which the position and direction of the wafer are not adjusted by the aligner 23, and the protective tape is peeled off after irradiation of ultraviolet rays, and the wafer is contained in the wafer cassette, differs from the present embodiment in that the dicing tape applying apparatus 30 is arranged adjacent to the polishing/back-grinding apparatus 10 and the UV irradiation apparatus 24, and the wafer is conveyed to the dicing tape applying apparatus 30 without the protective tape being peeled off after irradiation of ultraviolet rays.

In the dicing tape applying apparatus 30, the wafer is placed in a circular hole with its back facing upward because a frame 31 is already placed on a stage located at the part denoted by reference number 32. As described above, the position and direction of the wafer have already been adjusted by the aligner 23, it is accordingly arranged at a fixed position on the stage and is also arranged at a fixed position with respect to the frame 31. The wafer and the frame 31 fixed to the stage move to the position denoted by reference number 32 and enter a dicing tape applying apparatus 33 and, after the back is applied with the dicing tape, they are reversed in a reversing mechanism 34 and the protective tape on the surface of the wafer is peeled off in a protective tape peeling apparatus 35. Then, the wafer and the frame are conveyed from an unload section 36 to a dicing apparatus 91 and assembled into a package in an assembling apparatus 92, after being diced.

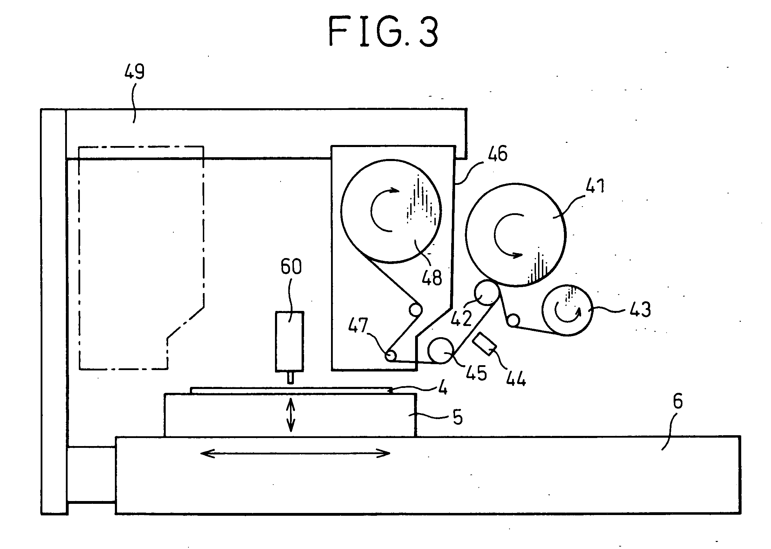

FIG.3 is a diagram that shows the configuration of the dicing tape applying apparatus 33 according to the present embodiment. As shown in FIG.3, the wafer and a frame (denoted by reference number 4 here) are absorbed onto a stage 5. The stage 5 can move both in the transverse and in the vertical directions owing to a moving mechanism 6. What is denoted by reference number 41 is a dicing tape supply reel that supplies the dicing tape, and the rotating shaft can take a stationary state or a state of free rotation in which the rotating shaft rotates by pulling the tape. The dicing tape is divided into the tape itself and the liner, that is, the surface cover, at the part of a roller 42, and the liner is rolled round a roller 43 in synchronization with supply of the tape. The roller 43 is not necessary for a dicing tape that does not use a liner. It is so designed that the tape itself is rolled round a roller 48 from the roller 42 via rollers 45 and 47. There is provided an edge detector 44 that detects the edge of the dicing tape between the rollers 42 and 45 in the case of the pre-cut dicing tape.

In addition, it is possible to detect the side or the rear edge of the tape by properly changing the mounting position of the edge detector 44.

The rollers 47 and 48 are attached to a moving member 46 and the moving member 46 is so restrained by a moving mechanism 49 that it can move to the right and left. The roller 47 is called the pinch roller and is able to move upward and downward and is pressed downward at a constant pressure. A cutter 60 is rotatably retained by a rotationally moving mechanism, although not shown here, and the edge of the cutter describes a circular locus around the hole of the frame.

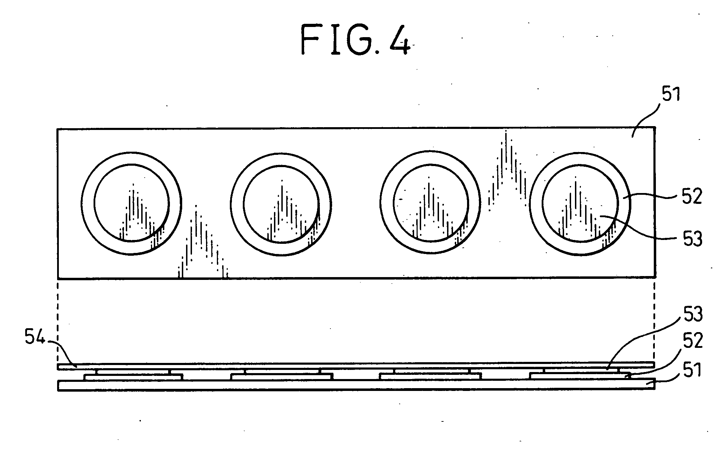

FIG.4 is a diagram that shows a pre-cut dicing tape. As shown in FIG.4, a circular dicing tape 52 is formed on a carrier tape 51, a circular die bonding tape 53 is formed thereon, and a liner 54 is further formed so as to cover the carrier tape 51. As shown in FIG.1, the dicing tape 52 is larger than the circular hole of the frame 2 but not larger than the frame 2. The die bonding tape 53 is a tape used to fix the back of the die to the package and has a circular shape equal in size to, or slightly larger than, the wafer. The carrier tape 51 and the liner 54 are made of materials that enable them to be easily peeled off from the dicing tape 52 and the die bonding tape 53. Here, the figure shows that the part of the carrier tape 51 on which neither dicing tape 52 nor die bonding tape 53 exists, is in direct contact with the liner 54, but the sole requirement is that neither dicing tape 52 nor die bonding tape 53 exists within an area a fixed distance from the circle of the dicing tape 52, therefore, the dicing tape 52 and the die boding tape 53 can exist on any area other than the specified area.

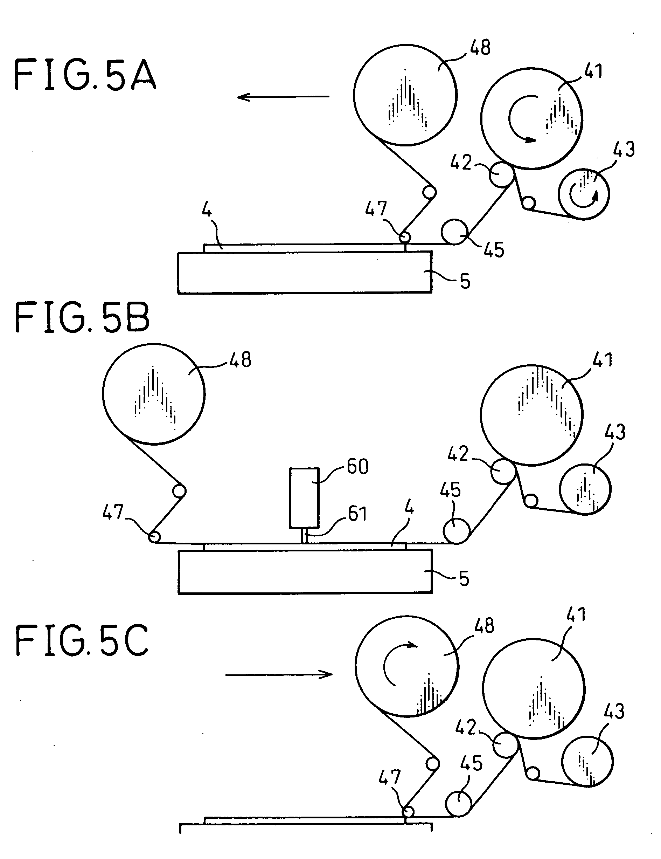

FIG.5A to FIG. 5C are diagrams that illustrate how the non-cut dicing tape is applied by the dicing tape applying apparatus. As shown in FIG.5A, the rollers 47 and 48 are located on the right-hand side and the right end of the pair of the wafer and frame is located near the roller 47. Then, the rotation of the roller 48 is terminated, the roller 41 is brought into a state of free rotation, and the moving member is moved to the left, thereby the rollers 47 and 48 move to the left. Therefore, the non-cut dicing tape is pulled out from the roller 41 and the non-cut dicing tape is pressed and applied to the backs of the wafer and the frame by the roller 47.

As shown in FIG. 5B, when a state is brought about in which the non-cut dicing tape is applied to the whole of the backs of the wafer and the frame, the cutter 60 moves onto the frame and the edge of a blade 61 comes into contact with the non-cut dicing tape on the frame. Then the cutter 60 moves rotationally and cuts the non-cut dicing tape into the shape shown in FIG.1.

Then, as shown in FIG.5C, the roller 41 is brought into a stationary state and rollers 47 and 48 are moved to the right by moving the moving member to the right while the roller 48 is being rotated. By this, the part of the non-cut dicing tape other than the circular part cut by the cutter is rolled round the roller 48. In addition, the fact that the direction of the non-cut dicing tape changes acutely at the part of the roller 48 is essential for the non-cut dicing tape other than the circular part to be peeled off.

In the above-mentioned manner, the dicing tape is applied to the backs of the wafer and the frame fixed to the stage as shown in FIG. 1A and FIG. 1B. This applies the case where the non-cut dicing tape, to which the die boding tape is bonded, is used. Moreover, in the state shown in FIG.5, it is possible to move the rollers 47 and 48 to the leftmost side in a state in which the stage is not raised and the non-cut dicing tape is not applied to the wafer and the frame, and then to apply the non-cut dicing tape to the whole surfaces of the wafer and the frame simultaneously by raising the stage.

When the pre-cut dicing tape is applied, the rollers 47 and 48 are moved to the right and the stage 5 is moved until the left end of the frame is located on the right-hand side of the roller 44. Then, the roller 41 is brought into a state of free rotation and the roller 48 is rotated. By this, the pre-cut dicing tape is supplied from the roller 41, then, the edge of the pre-cut dicing tape is detected by the edge detector 44 and, in synchronization with this, the movement of the stage to the left is started. As the stage moves at the same speed as that of the pre-cut dicing tape, the pre-cut dicing tape is applied to fixed positions of the frame and the wafer by pressing the roller 47 to the wafer and the frame. As the direction of the tape changes acutely at the part of the roller 47, the carrier tape is rolled round the roller 48, but the circular dicing tape and die bonding tape are applied to the frame and the wafer as is. In this way, if rolling by the roller 48 is terminated in a state in which the frame and the wafer have moved to the left beyond the part of the roller 47, the dicing tape is applied to the backs of the wafer and the frame fixed to the stage, as shown in FIG.1A and FIG.1B.

The protective tape peeling apparatus 35 has a structure, for example, as shown in FIG.3, and can be realized by an apparatus without a cutter. The protective tape peeling apparatus 35 heats the reversed wafer to lessen the adhesive force of the protective tape. Then, another adhesive tape is applied to the protective tape and when the adhesive tape is peeled off, the protective tape is peeled off together.

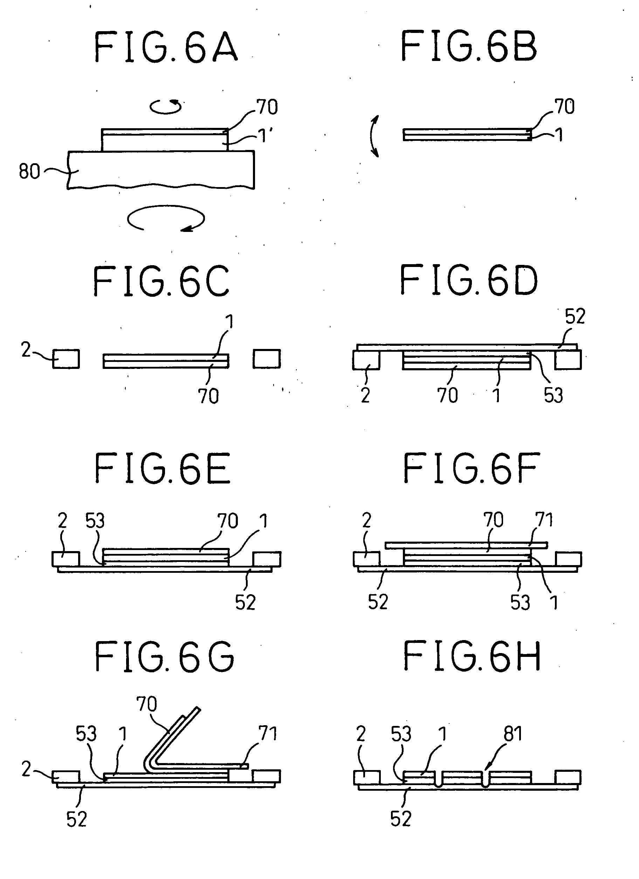

The section including the back-grinder and the dicing tape applying apparatus according to the embodiments of the present invention, is described as above. Here the changes of the tapes applied to the wafer surface in this process are described below by reference to FIG.6A to FIG.6H.

In the polishing/back-grinding apparatus, as shown in FIG.6A, a protective tape 70 is applied to the surface of a thick wafer 1' before it is thinned, and its back is ground and polished by a grind stone 80. Then, the thinned wafer 1, to which the protective tape 70 is applied, is cleaned as shown in FIG. 6B. After this, the wafer 1 is reversed so that the back faces upward. In the dicing tape applying apparatus 33, the wafer 1 is arranged with its back facing upward in the hole of the frame as shown in FIG. 6C, and the dicing tape 52 is applied to the backs of the frame 2 and the wafer 1 as shown in FIG.6D. At this time, if the pre-cut dicing tape, to which the die bonding tape 53 is bonded, is used, the die bonding tape 53 is applied only to the back of the wafer 1 and the dicing tape 52 is applied to it, as shown schematically.

After the reversing shown in FIG. 6E, a tape for peeling 71 is applied in the protective tape peeling apparatus 35 as shown in FIG.6F, and the protective 70 is peeled off together when the tape for peeling 71 is peeled off as shown in FIG.6G.

In the dicing apparatus, as shown in FIG.6H, grooves 81 are formed so as to exceed the thinned wafer 1 and the die bonding tape 53 and to reach until a halfway point in the dicing tape 52. In this state, by heating, cooling, or irradiating ultraviolet rays, the adhesive force of the dicing tape is lessened and each die can be easily peeled off from the dicing tape by means of vacuum absorption or the like. A material is selected for the die bonding tape 53 so that the adhesive force is not lessened in this situation.

As described above, the dicing tape applying apparatus according to the first aspect of the present invention can use both the non-cut dicing tape and the pre-cut dicing tape, therefore, it can be effective in that not only the cost of equipment can be reduced but also the space can be saved. In addition, the back-grinding/dicing tape applying system and the dicing tape applying apparatus according to the second and third aspects of the present invention can be effective in that the damage to the back-ground wafers can be reduced and the yield can be increased.

## Claims

1. A dicing tape applying apparatus applying a dicing tape to a wafer to be diced, comprising a stage retaining the wafer, a dicing tape supply mechanism able to set both a non-cut dicing tape and a pre-cut dicing tape and supplying the set non-cut dicing tape or the set pre-cut dicing tape, a pre-cut dicing tape edge position detector detecting the edge position of the pre-cut dicing tape when the pre-cut dicing tape is supplied from the dicing tape supply mechanism, an applying apparatus applying the non-cut dicing tape or the pre-cut dicing tape supplied from the dicing tape supply mechanism to the back of the wafer, and a cutter cutting the non-cut dicing tape into a desired shape when the non-cut dicing tape is applied.

2. A dicing tape applying apparatus, as set forth in claim 1, wherein the non-cut dicing tape and the pre-cut dicing tape comprise a dicing tape and a die bonding tape, and wherein the back of the wafer is bonded to the dicing tape via the die bonding tape.

3. A dicing tape applying apparatus, as set forth in claim 1 or 2, wherein a protective tape is applied to the surface of the wafer, to which the dicing tape is to be applied by the applying apparatus, and wherein a protective tape peeling mechanism is further provided for peeling off the protective tape after applying the dicing tape to the wafer.

4. A dicing tape applying apparatus applying a dicing tape to a wafer to be diced, comprising a stage retaining the wafer, an applying mechanism applying the dicing tape to the back of the wafer, and a protective tape peeling mechanism peeling off the protective tape applied to the surface of the wafer after applying the dicing tape to the wafer.

5. A back-grinding/dicing tape applying system, comprising a polishing/back-grinding apparatus for thinning a wafer by grinding and polishing the back of the wafer, on the surface of which semiconductor circuits are formed and to the surface of which a protective tape is applied, a dicing tape applying apparatus applying a dicing tape to the back of the thinned wafer, wherein the dicing tape applying apparatus peels off the protective tape after applying the dicing tape.

6. A back-grinding/dicing tape applying system, as set forth in claim 5, wherein the dicing tape applying apparatus is the apparatus set forth in any of claims 1 to 4.

7. A back-grinding/dicing tape applying system, comprising a back-grinder for thinning a wafer by grinding the back of the wafer, on the surface of which semiconductor circuits are formed, a dicing tape applying apparatus arranged adjacent to the back-grinder and applying a dicing tape to the back of the thinned wafer, and a conveying mechanism conveying the thinned wafer from the back-grinder to the dicing tape applying apparatus.
